# EUROPEAN PATENT SPECIFICATION

(11) **EP 1 408 586 B1**
(45) Date of publication and mention of the grant of the patent: **24.12.2008**
(21) Application number: 03021685.7
(22) Date of filing: 29.09.2003
(51) Int. Cl.: H01R 12/38, H01R 4/24

(54) **Crimp connector**
Crimpverbinder
Connecteur à sertir

(30) Priority: 07.10.2002 EP 02022305
(43) Date of publication of application: 14.04.2004
(73) Proprietor: Tyco Electronics AMP GmbH, 64625 Bensheim (DE)
(72) Inventor: Wendling, Hannes, 63225 Langen (DE); De Cloet, Olivier, 64625 Bensheim (DE); Jauris, Jonny, 63225 Langen (DE)
(74) Representative: Grünecker, Kinkeldey, Stockmair & Schwanhäusser Anwaltssozietät

(56) References cited:
- EP-A- 0 973 232
- US-A- 3 259 874
- US-A- 3 696 322
- US-A- 3 937 403
- US-A- 4 066 319
- US-A- 6 086 413

## Description

The invention relates to a crimp connector for electrically contacting an electrical conductor embedded in an insulating layer. The invention further relates to a method for electrically contacting an electrical conductor embedded in an insulating layer by means of a crimp connector.

Crimp connectors are a fast, economical and reliable type of electrical connection for electrical conductors. Crimp connectors are preferably used in motor vehicle electronic devices where electrical connections are subjected to extremely rough environmental conditions and must have vibration stability, resistance to corrosion, temperature stability and current-carrying capacity.

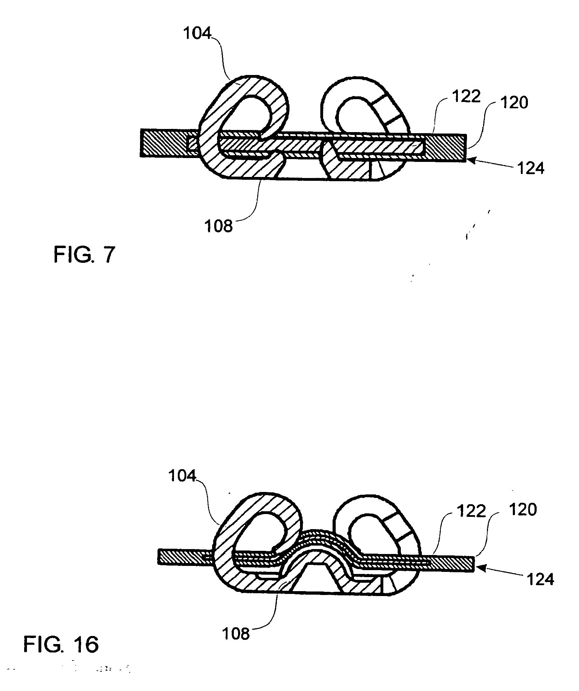

The crimp connectors are commonly provided with corresponding piercing tines that are used as penetration connectors for contacting foil electrical conductors, such as flexible flat cables (FFC) or flexible printed circuit boards (FPC). An example of this type of crimp connector is shown in Fig. 16. The crimp connector of Fig. 16 has a base 108, which may be connected, for example, to a plug contact, and at least one piercing tine 104 that contacts an electrical conductor 122 of a flat conductor 124 by penetrating insulating material 120 provided thereon. The piercing tines 104 may be formed with a tapering, sharp-edge-type structure, so they cut into the electrical conductor 122 during assembly, as shown, for example, in US 4,082,402 (Kincaid et al), US 4,106,836 (Asick et al), US 4,270,828 (Thurston) and US 4,669,798 (Daum et al). During assembly, the piercing tines 104 are pressed downward with the aid of a suitable crimping tool in a direction of the electrical conductor 122 to penetrate the insulating material 120 and contact the electrical conductor 122.

US 3,715,457 (Teagno et al) and US 3,697,925 (Henschen) further teach the crimp connector with bent-up edges for providing strain relief in addition to the actual crimped contact. Additionally, US 3,937,403 (Lawson) and US 3,960,430 (Bunnell et al) teach contacting the electrical conductors embedded in the insulating material exclusively via contact projections moulded onto the base of the crimp connector. The piercing tines, thereby only mechanically fix the crimp connector to the flat conductor and do not penetrate the insulating material.

There is a problem, however, in that in the above-described crimp connectors, a layer of the insulating material remains between the base of the crimp connector and the electrical conductor to be contacted, whereby changes in shape, caused by, e.g., thermal changes in the insulating material, may have a negative effect on the quality of the electrical contact. For example, in the use of extruded flat conductors (exFLC) (which are increasingly employed in automobile construction, ship and aircraft cabling or industrial computers, because they are inexpensive and offer the advantage of more flexibility, space-saving and absolute water-tightness) where no prefabricated laminating foils have to be additionally bought and the plastics material sleeve is made directly from a granulate, the extruded foils may be subjected to high temperatures that cause the plastic materials of the insulating material to yield during thermal loading (US 4,082,402 and US 4,669,798).

A solution to this problem is accorded in US 3,697,925 wherein the electrical conductor is stripped of the insulating material prior to attachment of the crimp connector. This solution, however, has the disadvantage in that defined removal of the insulating material is time-consuming and technically demanding. For example, this process requires the use of high-precision milling technology or expensive laser technology. Moreover, susceptibility to corrosion in the contact zone is increased, and mechanical stability is reduced.

From US-A-3,696,322 which discloses a connector according to the preamble of claim 1 a crimped connector for insulated flat wires is known wherein the tines of a rosette 31 pierce the insulation from one side. The upstanding ferrule side walls are rolled in towards the middle of the connector in order to provide a strain relief and an electrical contact.

From US-A-3,259,874 an insulating piercing electrical connector is known, wherein lances penetrate the insulation and engage in an electrically conducting contact with the strands of the core of the conductor. Moreover, a protuberance having a pyramid form is provided to puncture the outer surface of the insulation without penetrating same and to serve as a strain relief.

EP-A-0 973 232 shows electrical contacts for contacting foil conductors, wherein on the base plate protruding sections are provided which engage electrically with the foil conductor by causing a scraping or stripping of the insulating foil layer.

The US patent US-A-6,086,413 discloses a multiple wire connector wherein a connector receptacle has a conductive insert stamped from a flat sheet stock with individual crimp type wire lead terminals formed integrally herewith. Barbed pin-receiving apertures are formed in the insert and provide the necessary electrical contact.

From US-A-4,066,319, a termination method and apparatus for flexible flat conductor cables is known, that utilizes a contact having a pair of cable penetrating prongs for penetrating completely through a connector of the flexible cable and a pair of biased abutment surfaces co-operable with the prongs performing a crimp at a location remote from the penetration. The prongs may be arranged in a manner to form a biased contact bridge there between after the connector has been attached to the cable.

An object of the invention is to provide an improved crimp connector that can be assembled easily, inexpensively and efficiently while ensuring safe electrical contact even in cases where there are thermal changes in the properties of the insulating material.

This and other object are achieved by a crimp connector having a crimping region including a base having at least one contact strip and at least one piercing tine. The at least one contact strip has a tapered tip and is arranged on the base such that the tapered tip penetrates an insulating material of a conductor from a lower surface to contact an electrical conductor therein when crimped. The at least one piercing tine has a tapered end region and is arranged on the base such that the tapered end region penetrates the insulating material of the conductor from an upper surface to contact the electrical conductor therein when crimped.

The at least one contact strip has a pyramid-shaped structure and is adapted to guide the at least one piercing time into contact with the electrical conductor.

This and other object are further achieved by a method for electrically contacting at least one electrical conductor embedded in an insulating material. A conductor is positioned adjacent to a contact strip arranged on base of a crimp connector. A piercing tine arranged on the base so that the crimp connector is deformed to at least partially encircle the conductor. An upper surface of the insulating material is penetrated with a tip of the piercing tine. A lower surface of the insulating material is penetrated with a tip of the contact strip. The respective tips of the piercing tine and the contact strip contact the electrical conductor.

The at least one contact strip has a pyramid-shaped structure and is adapted to guide the at least one piercing time into contact with the electrical conductor.

The invention is described in greater detail below with reference to the attached figures, in which:
Fig. 1 is a perspective view of a crimping region of a first embodiment of a crimp connector.
Fig. 2 is a top view of a horizontal projection on the crimp connector of Fig. 1.
Fig. 3 is a side view of the crimp connector of Fig. 1.
Fig. 4 is a sectional view of the crimp connector of Fig. 1 taken along line B-B of Fig.
Fig. 5 is a sectional view of the crimp connector of Fig. 1 taken along line A-A of Fig. 2.
Fig. 6 is a partial view of the punch tape layout for the crimp connector.
Fig. 7 is a sectional view through the crimp connector in a crimped state.
Fig. 8 is a sectional view of a crimp connector taken along line C-C of Fig. 9.
Fig. 9 is a top view of a horizontal projection on a crimp connector.
Fig. 10 is a sectional view of a crimp connector taken along line D-D of Fig. 11.
Fig. 11 is a top view of a horizontal projection on another crimp connector.
Fig. 12 is a sectional view of a crimp connector taken along line E-E of Fig. 13.
Fig. 13 is a top view of a horizontal projection on still another crimp connector.
Fig. 14 is a sectional view of a crimp connector taken along line F-F of Fig. 15.
Fig. 15 is a top view of a horizontal projection on still another crimp connector.
Fig. 16 is a sectional view through a conventional crimp connector in a crimped state.

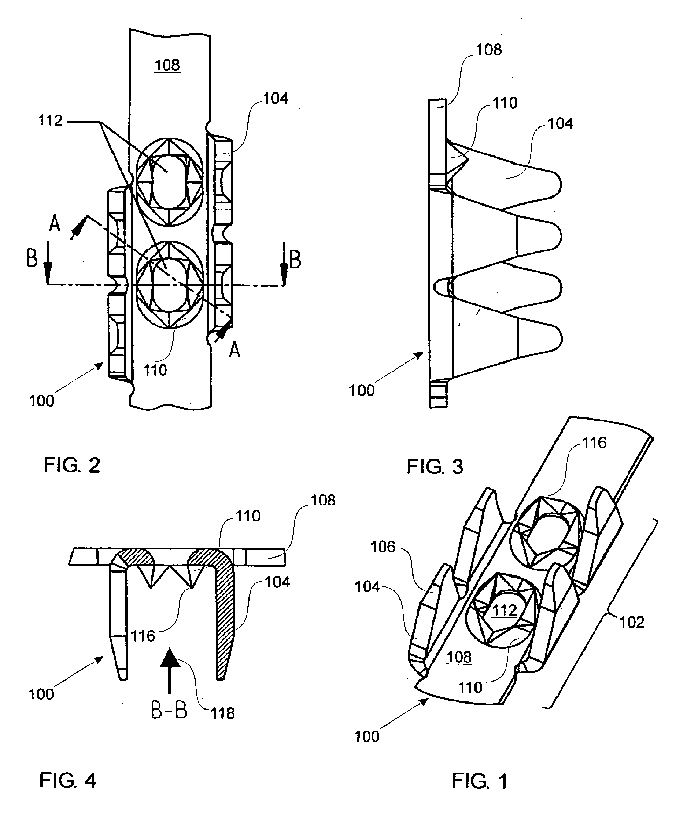

Figs. 1-7 show a first embodiment of a crimp connector 100. Only an actual crimping region 102 of the crimp connector 100 is shown. A second crimping region or a plug-in connector element, for example, may adjoin the crimping region 102. The crimp connector 100 may also only consist of the crimping region 102 shown and, thus, be used as a penetration connector for connecting a plurality of insulating foils with embedded flexible electrical conductor paths.

The crimp connector 100 has a base 108 provided with four elliptical orifices 112. Although the orifices 112 in the embodiment shown have an elliptical shape, the orifices 112 are not restricted to this shape and may be shaped in any other desired configuration, for example, the orifices 112 may be circular or rectangular. A contact strip 110 is arranged around each of the elliptical orifices 112. As best shown in Figs. 3 and 4, the contact strips 110 have an approximately pyramid-shaped structure with a sharply tapering tip 116 in an end region.

Four piercing tines 104 extend from sides of the base 108. The piercing tines 104 have tapering end regions 106. Although in the embodiment shown all four piercing tines are shaped identically, the piercing tines 104 may also be configured at different heights in order to be able to achieve different penetration depths, e.g., with multiple-layered wiring. For example, the piercing tines 104 located diagonally opposite one another may be of an identical shape. Additionally, although the number of piercing tines 104 in the embodiment shown is four, any number of piercing tines 104 may be used depending on the desired configuration of the crimp connector 100.

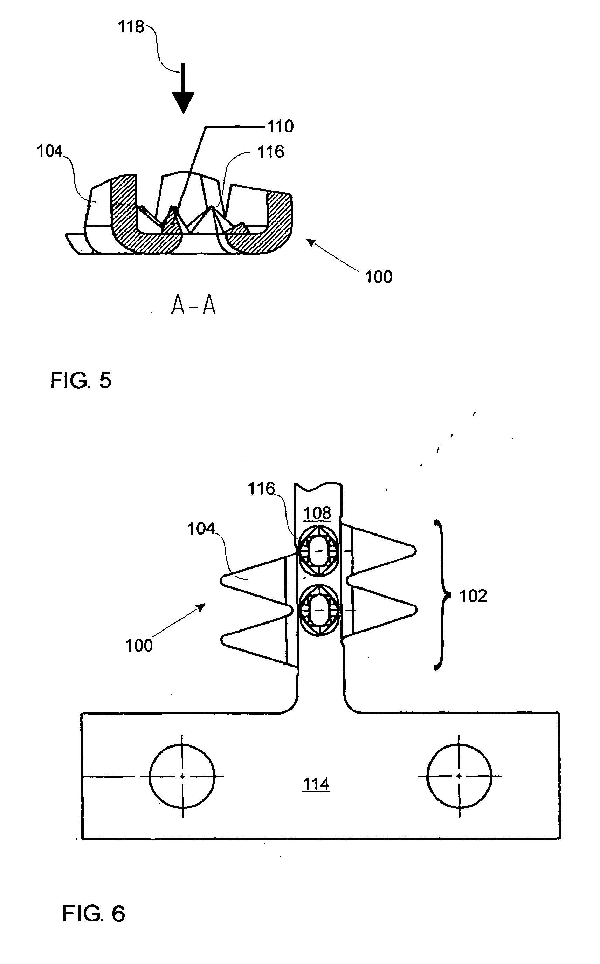

As shown in Figure 6, in a delivery state a plurality of the crimp connectors 100 may be connected to one another via subsequently removable punch tape webs 114.

The assembly of the crimp connector 100 to a flat conductor 124 will now be described with reference to Fig. 7. The flat conductor 124 includes an electrical conductor 122 and insulating material 120, as shown in Fig. 7. The flat conductor 124 is positioned above the crimp connector 100 and pressed in direction 118. With the aid of a suitable crimping tool, pressure is exerted in the direction 118 and onto the piercing tines 104 so that the piercing tines 104 bend in the shape of a semi-circle, as shown in Fig. 7. The piercing tines 104 are bent until end regions of the piercing tines 104 cut through the insulating material 120 and contact the electrical conductor 122. The pyramid-shaped configuration of the contact strips 110, in particular the bevelled outer flanks facing the piercing tines 104, guide the piercing tines 104 to promote arch-shaped bending. Simultaneously, the contact strips 110 penetrate the insulating material 120 from below and come into electrical contact with the electrical conductor 122. The tapering tips 116 allow for a considerable mechanical force to be exerted on the insulating material 120 of the flat conductor 124 when pressure is applied in the direction 118, so that the contact strips 110 cut through the insulating material 120 and the electrical conductor 122.

After penetration of the insulating material 120 by the tapering tips 116, the insulating material 120 hermetically seals against corrosive environmental influences around the piercing tines 104 and the contact strips 110. Further, because the end regions of the piercing tines 104 and the tapering tips 116 of the contact strips 110 are substantially opposite one another, a favourable mechanical force distribution takes place that securely holds the electrical conductor 122 even in rough environmental conditions. The electrical conductor 122 is thereby securely clamped between the piercing tines 104 and the contact strips 110 without the insulating material 120 enclosed therebetween.

Although in Fig. 7 only one flat conductor 124 is shown, the crimp connector 100 may also be used, for example, with multiple flat conductors 124 positioned on top of one another. The height of the contact strips 110 may then be adjusted to contact different electrical conductors 122 of the stacked flat conductors 124. Additionally, the crimp connector 100 may be used with electrical conductors other that the flat conductor 124 with the rectangular cross-section that is shown, for example, the electrical conductor may have any other cross-sectional configuration, such as circular.

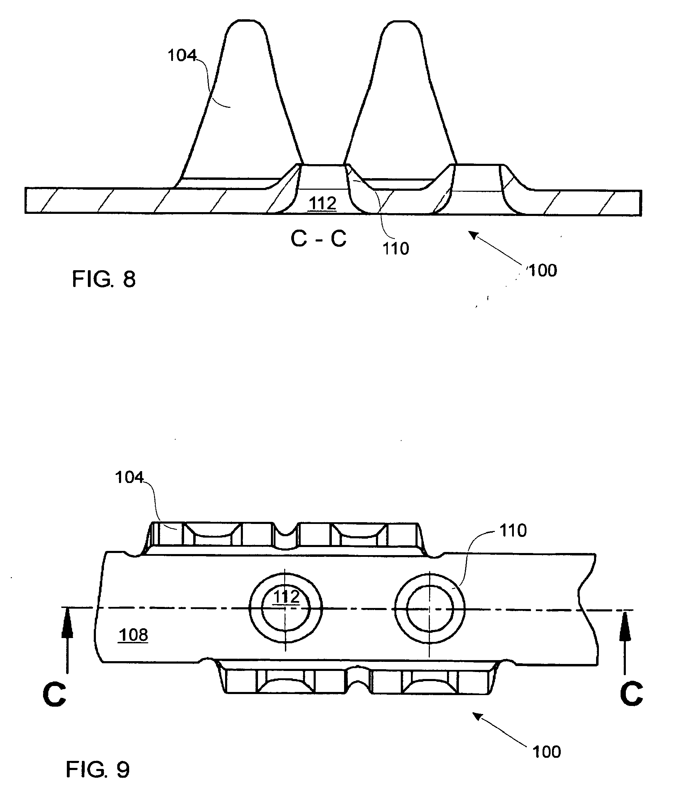

Figs. 8 and 9 show another structure of a crimp connector 100. This structure differs from the first embodiment in that same has two cone-shaped contact strips 110 with circular orifices 112. The contact strips 110 have annular sharp edges that ensure reliable contact with the electrical conductor 122.

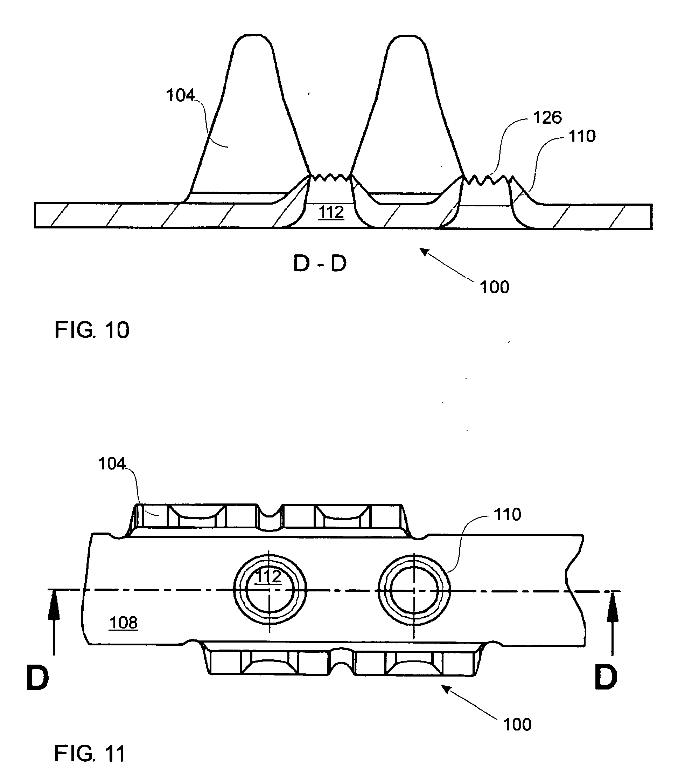

Figs. 10 and 11 show still another form of a crimp connector 100. This form differs from the first embodiment in that in same the contact strips 110 have annular sharp edges formed by a set of teeth 126 provided thereon.

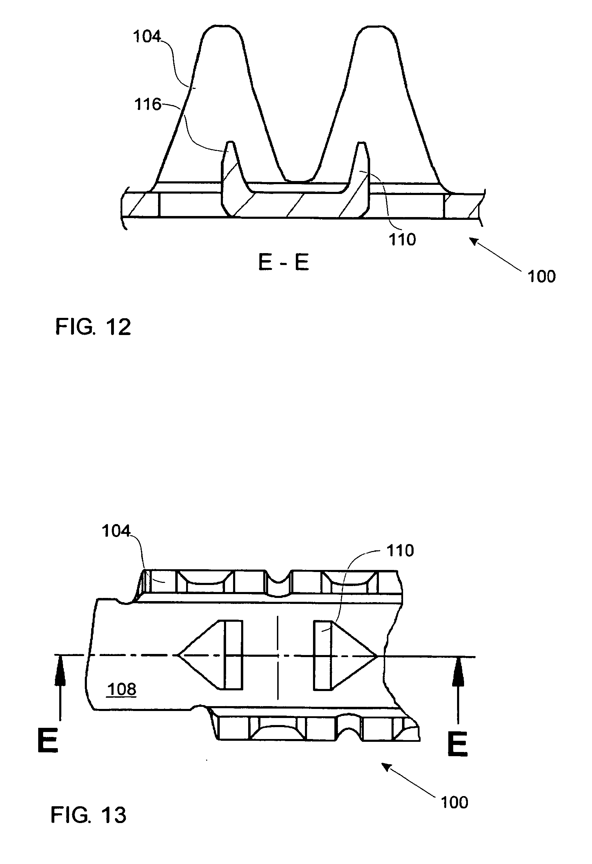

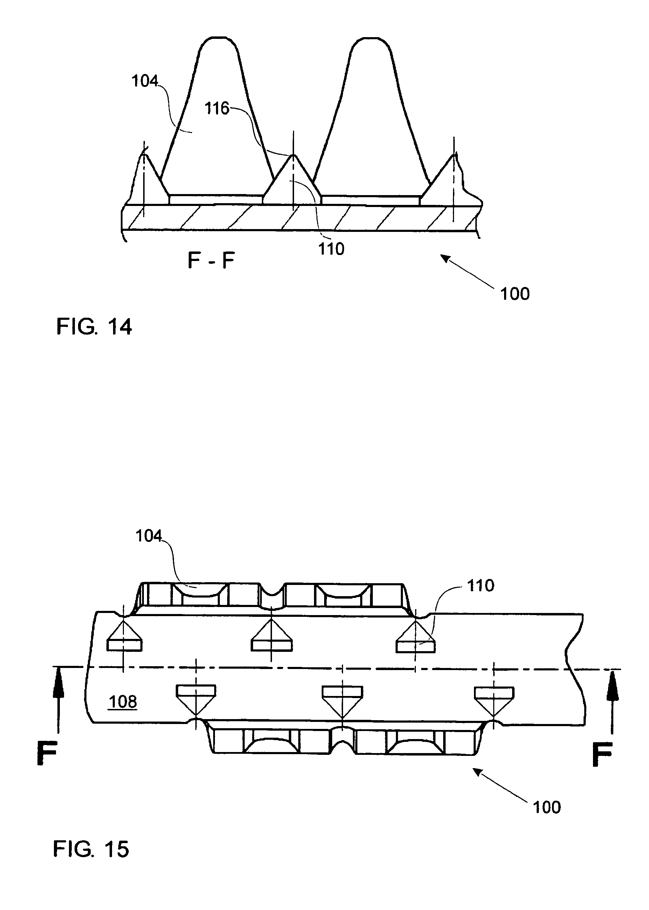

Figs. 12-15 show a further structure of a crimp connector 100. This structure differs from the first embodiment in that in same the contact strips 110 are formed by being individually bent-up from the base 108. A base line of the contact strips 110 may run either substantially transversely to a longitudinal axis of the crimp connector 100, as shown in Figs. 12 and 13, or, as shown in Figs. 14 and 15, parallel thereto. In each case the tip 116 is configured for optimally contacting the electrical conductor 122.

Because the contact strip 110 arranged in the base 108 of the crimp connector 100 penetrates the insulating material 120 and electrically contacts the electrical conductor 122 in addition to the piercing tine 104, the electrical conductor 122 is contacted from an upper and lower side to ensure a particularly safe and stable electrical connection. Hence, no insulating material 120 having temperature-dependent mechanical properties is contained in the contacting bond, and a stable electrical connection is guaranteed even at higher operating temperatures. The geometric configuration of the base 8 to have a pointed contact strip 110 or a plurality of strips 110 has the advantage that the insulating material 120 may be easily penetrated to eliminate the need for stripping the flat conductor 124. The pointed strip 110 additionally has the advantage that the imperviousness of the insulating material 120 to environmental influences continues to be maintained and, thus, corrosion may be effectively prevented. The properties of the crimp connector 100 are particularly advantageous if the insulating material 120 is a foil. Because foils are widespread and crimping of the electrical conductors therein has proved to be a particularly advantageous contacting method, the crimp connector 100 ensures a particularly stable and safe contact is produced.

In order to guarantee stable, safe contact, even with large tolerance differences between the geometry of the electrical conductor 122 and the insulating material 120, the base 108 is provided with at least one ring of contact strips 110 that is formed by a multiplicity of contact strips 110 arranged substantially annularly around a common center point or by individually erected contact strips 110. Particularly safe and, with respect to mechanical loading, stable electrical and mechanical contact may also be achieved by a crimp connector 100 that has four or more piercing tines 104 which are arranged substantially opposite one another and offset in pairs wherein the piercing tines 104 are bent towards one another and form a frictional connection to the contact strip 110 arranged on the base 108 between the piercing tines 104. Further, because deformation of the piercing tine 104 takes place by means of a crimping tool that presses with a defined force against the piercing tine 104, a particularly reliable electrical contact is guaranteed.

The method for electrically contacting at least one electrical conductor 122 embedded in the insulating material 120 by means of the crimp connector 100 is particularly inexpensive and time-saving, because stripping the flat conductor 124 before attaching the crimp connector 100 is not necessary.

## Claims

1. A crimp connector (100) having a crimping region (102),
wherein the crimping region (102) has a base (108) having at least one contact strip (110) and at least one piercing tine (104);
the at least one contact strip (110) having a tapered tip (116) and arranged on the base (108) such that the tapered tip (116) penetrates an insulating material (120) of a conductor (124) from a lower surface to contact an electrical conductor (122) therein when crimped; and
the at least one piercing tine (104) having a tapered end region (106) and arranged on the base (108) such that the tapered end region (106) penetrates the insulating material (120) of the conductor (124) from an upper surface to contact the electrical conductor (122) therein when crimped,
**characterised in**
**that** the at least one contact strip (110) has a pyramid-shaped structure and is adapted to guide the at least one piercing tine (104) into contact with the electrical conductor (122).

2. The crimp connector (100) of claim 1, **characterised in that** the at least one piercing tine (104) extends from a side of the base (108).

3. The crimp connector (100) of claim 1 or 2, **characterised in that** the base (108) includes at least one orifice (112) around which the at least one contact strip (110) is arranged.

4. The crimp connector (100) of any one of claims 1-3, **characterised in that** the at least one contact strip (110) includes teeth (126) for penetrating the insulating material (120).

5. The crimp connector (100) of any one of claims 1-4, **characterised in that** the at least one contact strip (110) is bent-up from the base (108).

6. The crimp connector (100) of any one of claims 1-5, **characterised in that** the insulating material (120) is a foil.

7. The crimp connector (100) of any one of claims 1-6, **characterised in that** the at least one contact strip (110) and the at least one piercing tine (104) form a semicircular arc when crimped.

8. The crimp connector (100) of any one of claims 1-7, **characterised in that** the at least one contact strip (110) and the at least one piercing tine (104) are moulded with the base (108).

9. The crimp connector (100) of any one of claims 1-8, **characterised in that** the at least one contact strip (110) is arranged substantially annularly around a common centre point of the base (108).

10. The crimp connector (100) of any one of claims 1-9, **characterised in that** the base (108) includes a pair of the piercing tines (104) arranged on opposing sides, the pairs being mutually offset from each other.

11. The crimp connector (100) of any one of claims 1-10, **characterised in that** the each of the pairs are arranged on the base (108) to flank the at least one contact strip (110).

12. A method for electrically contacting at least one electrical conductor (122) embedded in an insulating material (120), comprising the following steps:
positioning a conductor (124) adjacent to a contact strip (110) arranged on base (108) of a crimp connector (100);
deforming a piercing tine (104) arranged on the base (108) so that the crimp connector (100) at least partially encircles the conductor (124);
penetrating an upper surface of the insulating material (120) with a tip (106) of the piercing tine (104);
penetrating a lower surface of the insulating material (120) with a tip (116) of the contact strip (110);
contacting the electrical conductor (122) with the respective tips (106, 116) of the piercing tine (104) and the contact strip (110),
**characterised in**
**that** the at least one contact strip (110) has a pyramid-shaped structure and guides the at least one piercing tine (104) into contact with the electrical conductor (122).

13. The method of claim 12, further **characterised in that** the method includes applying a crimping tool to the crimp connector (100).

14. The method of claim 12 or 13, further **characterised in that** the upper surface of the insulating material (120) and the lower surface of the insulating material (120) are simultaneously penetrated.

15. The method of one of claims 12-14, further **characterised in that** the method includes clamping the conductor (124) between the piercing tine (104) and the contact strip (110).

## Patentansprüche

1. Crimpverbinder (100) mit einem Crimpbereich (102),
worin der Crimpbereich (102) eine Basis (108) mit mindestens einem Kontaktstreifen (110) und mindestens eine Durchdringungsflanke (104) aufweist,
wobei der mindestens eine Kontaktstreifen (110) eine verjüngte Spitze (116) aufweist und auf der Basis (108) so angeordnet ist, dass die verjüngte Spitze (116) ein isolierendes Material (120) eines Leiters (124) von einer unteren Fläche durchdringt, um einen elektrischen Leiter (122) darin zu kontaktieren, wenn gecrimpt wird, und
die mindestens eine Durchdringungsflanke (104) einen verjüngten Endbereich (106) aufweist und auf der Basis (108) so angeordnet ist, dass der verjüngte Endbereich (106) das isolierende Material (120) des Leiters (124) von einer oberen Fläche durchdringt, um den elektrischen Leiter (122) zu kontaktieren, wenn gecrimpt wird,
**dadurch gekennzeichnet,**
**dass** der mindestens eine Kontaktstreifen (110) einen pyramidenförmigen Aufbau aufweist und ausgeführt ist, um die mindestens eine Durchdringungsflanke (104) in Kontakt mit dem elektrischen Leiter (122) zu führen.

2. Crimpverbinder (100) nach Anspruch 1, **dadurch gekennzeichnet, dass** sich die mindestens eine Durchdringungsflanke (104) von einer Seite der Basis (108) erstreckt.

3. Crimpverbinder (100) nach Anspruch 1 oder 2, **dadurch gekennzeichnet, dass** die Basis (108) mindestens eine Öffnung (112) umfasst, um die der mindestens eine Kontaktstreifen (110) angeordnet ist.

4. Crimpverbinder (100) nach einem der Ansprüche 1 bis 3, **dadurch gekennzeichnet, dass** der mindestens eine Kontaktstreifen (110) Zähne (126) für das Durchdringen des isolierenden Materials (120) umfasst.

5. Crimpverbinder (100) nach einem der Ansprüche 1 bis 4, **dadurch gekennzeichnet, dass** der mindestens eine Kontaktstreifen (110) von der Basis (108) nach oben gebogen ist.

6. Crimpverbinder (100) nach einem der Ansprüche 1 bis 5, **dadurch gekennzeichnet, dass** das isolierende Material (120) eine Folie ist.

7. Crimpverbinder (100) nach einem der Ansprüche 1 bis 6, **dadurch gekennzeichnet, dass** der mindestens eine Kontaktstreifen (110) und die mindestens eine Durchdringungsflanke (104) im gecrimpten Zustand einen halbkreisförmigen Bogen bilden.

8. Crimpverbinder (100) nach einem der Ansprüche 1 bis 7, **dadurch gekennzeichnet, dass** der mindestens eine Kontaktstreifen (110) und die mindestens eine Durchdringungsflanke (104) mit der Basis (108) geformt werden.

9. Crimpverbinder (100) nach einem der Ansprüche 1 bis 8, **dadurch gekennzeichnet, dass** der mindestens eine Kontaktstreifen (110) im Wesentlichen ringförmig um einen gemeinsamen Mittelpunkt der Basis (108) angeordnet ist.

10. Crimpverbinder (100) nach einem der Ansprüche 1 bis 9, **dadurch gekennzeichnet, dass** die Basis (108) ein Paar Durchdringungsflanken (104) umfasst, die auf entgegengesetzten Seiten angeordnet sind, wobei die Paare gegenseitig zueinander versetzt sind.

11. Crimpverbinder (100) nach einem der Ansprüche 1 bis 10, **dadurch gekennzeichnet, dass** ein jedes der Paare auf der Basis (108) angeordnet ist, um den mindestens einen Kontaktstreifen (110) zu flankieren.

12. Verfahren zum elektrischen Kontaktieren mindestens eines elektrischen Leiters (122), der in einem isolierenden Material (120) eingebettet ist, das die folgenden Schritte aufweist:
Positionieren eines Leiters (124) benachbart einem Kontaktstreifen (110), der auf der Basis (108) eines Crimpverbinders (100) angeordnet ist;
Verformen einer Durchdringungsflanke (104), die auf der Basis (108) angeordnet ist, so dass der Crimpverbinder (100) mindestens teilweise den Leiter (124) umschließt;
Durchdringen einer oberen Fläche des isolierenden Materials mit einer Spitze (106) der Durchdringungsflanke (104);
Durchdringen einer unteren Fläche des isolierenden Materials (120) mit einer Spitze (116) des Kontaktstreifens (110);
Kontaktieren des elektrischen Leiters (122) mit den jeweiligen Spitzen (106, 116) der Durchdringungsflanke (104) und des Kontaktstreifens (110);
**dadurch gekennzeichnet,**
**dass** der mindestens eine Kontaktstreifen (110) einen pyramidenförmigen Aufbau aufweist und die mindestens eine Durchdringungsflanke (104) in Kontakt mit dem elektrischen Leiter (122) führt.

13. Verfahren nach Anspruch 12, außerdem **dadurch gekennzeichnet, dass** das Verfahren das Verwenden eines Crimpwerkzeuges beim Crimpverbinder (100) umfasst.

14. Verfahren nach Anspruch 12 oder 13, außerdem **dadurch gekennzeichnet, dass** die obere Fläche des isolierenden Materials (120) und die untere Fläche des isolierenden Materials (120) gleichzeitig durchdrungen werden.

15. Verfahren nach einem der Ansprüche 12 bis 14, außerdem **dadurch gekennzeichnet, dass** das Verfahren das Festklemmen des Leiters (124) zwischen der Durchdringungsflanke (104) und dem Kontaktstreifen (110) umfasst.

## Revendications

1. Connecteur de sertissage (100) comportant une région de sertissage (102),
la région de sertissage (102) comportant une base (108) avec au moins une bande de contact (110) et au moins une dent de percement (104);
la au moins une bande de contact (110) comportant une pointe effilée (116) et étant agencée sur la base (108) de sorte que la pointe effilée (116) pénètre dans un matériau isolant (120) d'un conducteur (124) à partir d'une surface inférieure pour établir un contact avec un conducteur électrique (122) lors du sertissage; et
la au moins une dent de percement (104) comportant une région d'extrémité effilée (106) et étant agencée sur la base (108) de sorte que la région d'extrémité effilée (106) pénètre dans le matériau isolant (120) du conducteur (124) à partir d'une surface supérieure pour établir un contact avec un conducteur électrique (122) lors du sertissage;
**caractérisé en ce que** la au moins une bande de contact (110) a une structure de forme pyramidale et est destinée à guider la au moins une dent de percement (104) en contact avec le conducteur électrique (122).

2. Connecteur de sertissage (100) selon la revendication 1, **caractérisé en ce que** la au moins une dent de percement (104) s'étend à partir d'un côté de la base (108).

3. Connecteur de sertissage (100) selon les revendications 1 ou 2, **caractérisé en ce que** la base (108) englobe au moins un orifice (112) autour duquel est agencée la au moins une bande de contact (110).

4. Connecteur de sertissage (100) selon l'une quelconque des revendications 1 à 3, **caractérisé en ce que** la au moins une bande de contact (110) englobe des dents (126) destinées à pénétrer dans le matériau isolant (120).

5. Connecteur de sertissage (100) selon l'une quelconque des revendications 1 à 4, **caractérisé en ce que** la au moins une bande de contact (110) est repliée vers le haut à partir de la base (108).

6. Connecteur de sertissage (100) selon l'une quelconque des revendications 1 à 5, **caractérisé en ce que** le matériau isolant (120) est constitué par une feuille.

7. Connecteur de sertissage (100) selon l'une quelconque des revendications 1 à 6, **caractérisé en ce que** la au moins une bande de contact (110) et la au moins une dent de percement (104) forment un arc semi-circulaire lors du sertissage.

8. Connecteur de sertissage (100) selon l'une quelconque des revendications 1 à 7, **caractérisé en ce que** la au moins une bande de contact (110) et la au moins une dent de percement (104) sont moulées avec la base (108).

9. Connecteur de sertissage (100) selon l'une quelconque des revendications 1 à 8, **caractérisé en ce que** la au moins une bande de contact (110) est agencée de manière pratiquement circulaire autour d'un point central commun de la base (108).

10. Connecteur de sertissage (100) selon l'une quelconque des revendications 1 à 9, **caractérisé en ce que** la base (108) englobe une paire de dents de percement (104) agencée sur des côtés opposés, les paires étant mutuellement décalées l'une de l'autre.

11. Connecteur de sertissage (100) selon l'une quelconque des revendications 1 à 10, **caractérisé en ce que** chacune des paires est agencée sur la base (108) pour flanquer la au moins une bande de contact (110).

12. Procédé d'établissement d'un contact électrique avec au moins un conducteur électrique (122) encastré dans un matériau isolant (120), comprenant les étapes ci-dessous:
positionnement d'un conducteur (124) en un point adjacent à une bande de contact (110) agencée sur la base (108) d'un connecteur de sertissage (100);
déformation d'une dent de percement (104) agencée sur la base (108), de sorte que le connecteur de sertissage (100) encercle au moins partiellement le conducteur (124);
pénétration d'une surface supérieure du matériau isolant (120) par une pointe (106) de la dent de percement (104);
pénétration d'une surface inférieure du matériau isolant (120) par une pointe (116) de la bande de contact (110);
établissement d'un contact entre le conducteur électrique (122) et les pointes respectives (106, 116) de la dent de percement (104) et de la bande de contact (110);
**caractérisé en ce que**
la au moins une bande de contact (110) a une structure de forme pyramidale et guide la au moins une dent de percement (104) en contact avec le conducteur électrique (122).

13. Procédé selon la revendication 112, **caractérisé en outre en ce que** le procédé englobe l'étape d'application d'un outil de sertissage sur le connecteur de sertissage (100).

14. Procédé selon les revendications 12 ou 13, **caractérisé en outre en ce que** la surface supérieure du matériau isolant (120) et la surface inférieure du matériau isolant (120) sont pénétrées de manière simultanée.

15. Procédé selon l'une des revendications 12 à 14, **caractérisé en outre en ce que** le procédé englobe l'étape de serrage du conducteur (124) entre la dent de percement (104) et la bande de contact (110).
